# EUROPÄISCHE PATENTSCHRIFT

(11) **EP 0 315 080 B1**
(45) Veröffentlichungstag und Bekanntmachung des Hinweises auf die Patenterteilung: **20.01.1993**
(21) Anmeldenummer: 88118036.8
(22) Anmeldetag: 29.10.1988
(51) Int. Cl.: G03F 7/039, G03F 7/023

(54) **Strahlungsempfindliches Gemisch**
Light-sensitive composition
Compositions photosensible

(30) Priorität: 06.11.1987 DE 3737734
(43) Veröffentlichungstag der Anmeldung: 10.05.1989
(73) Patentinhaber: HOECHST AKTIENGESELLSCHAFT, 65926 Frankfurt am Main (DE)
(72) Erfinder: Elsässer, Andreas, Dr. Dipl.-Chem., D-6270 Idstein (DE)

(56) Entgegenhaltungen:
- EP-A- 0 042 562
- FR-A- 2 389 155

## Beschreibung

Die Erfindung betrifft ein positiv arbeitendes strahlungsempfindliches Gemisch, das als wesentliche Bestandteile
a) eine unter Einwirkung von aktinischer Strahlung eine starke Säure bildende Verbindung,
b) eine Verbindung mit mindestens einer durch Säure spaltbaren C-O-C-Bindung und ggf.
c) ein polymeres Bindemittel
enthält. Das Gemisch ist insbesondere zur Herstellung von Druckplatten und Photoresists geeignet.

Derartige Gemische und daraus hergestellte Aufzeichnungsmaterialien sind bekannt und z. B. in den US-A 3 915 706, 3 917 483, 3 779 778 und 3 984 253, in den DE-A 26 10 842, 27 18 254 und 30 23 201 und der EP-A 22 571 beschrieben. Sie sind wesentlich lichtempfindlicher als die sonst üblichen positiv arbeitenden strahlungsempfindlichen Aufzeichnungsmaterialien auf Basis von 1,2-Chinondiaziden.

Ein Nachteil dieser Aufzeichnungsmaterialien ist es, daß sie in Verbindung mit den für photolithographische und reprographische Langzeitanwendungen üblichen Trägermaterialien, z. B. Aluminium, Kupfer, Stahl, Zink, Messing, Chrom und Kunststoffolien, keine befriedigende Lagerfähigkeit aufweisen. Die mangelnde Lagerstabilität äußert sich darin, daß die Lichtempfindlichkeit der strahlungsempfindlichen Schichten allmählich abnimmt, bis zuletzt eine einwandfreie Entwicklung der Schichten nicht mehr möglich ist und die Materialien für photolithographische und reprographische Anwendungen nicht mehr zu gebrauchen sind.

Weiterhin müssen bei der zwischen Belichtung und Entwicklung erforderlichen oder zumindest vorteilhaften und üblichen Temperung relativ enge Bedingungen eingehalten werden. Es wurde bereits in der älteren deutschen Patentanmeldung P 37 15 790 vorgeschlagen, diese Nachteile durch Aufbringen einer entwicklerlöslichen Deckschicht, z. B. aus Polyvinylalkohol, auf die strahlungsempfindliche Schicht zu vermeiden. Diese Maßnahme führt zu einer deutlichen Verbesserung, jedoch ist die doppelte Beschichtung technologisch aufwendiger, und die Ansammlung der hochpolymeren Deckschichtbestandteile im Entwickler führt zu dessen rascherer Erschöpfung bzw. zu einem höheren Verbrauch.

In der DE-C 23 06 248 werden u. a. polymere säurespaltbare Acetale beschrieben, die entweder Acetalgruppen in der Hauptkette oder in Seitenketten enthalten. Im letzteren Fall werden z. B. die phenolischen Hydroxygruppen von Phenolharzen acetalisiert. Die entstehenden aromatischen Acetalgruppen ergeben Gemische mit geringerer Lichtempfidlichkeit als rein aliphatische Acetale; auch ist die bei der Spaltung dieser Verbindungen erzielte Löslichkeitsdifferenzierung oft nicht ausreichend.

In der DE-C 27 18 254 werden rein aliphatische Polyacetale beschrieben, und es wird erwähnt, daß deren Molekulargewicht durch Umsetzen mit Diisocyanaten oder Diepoxiden erhöht werden kann. Die dabei erhaltenen polymeren Verbindungen ergeben jedoch wiederum Gemische mit deutlich herabgesetzter Lichtempfindlichkeit.

Aufgabe der Erfindung war es, positiv arbeitende strahlungs- bzw. lichtempfindliche Gemische sowie Aufzeichnungsmaterialien auf Basis säurespaltbarer Verbindungen bereitzustellen, die eine bessere Lagerfähigkeit als die bisher bekannten Gemische dieser Art aufweisen, die einen breiteren Spielraum beim Nacherwärmen der belichteten Materialien vor dem Entwickeln zulassen und die keine zusätzliche Deckschicht erfordern.

Erfindungsgemäß wird ein strahlungsempfindliches Gemisch vorgeschlagen, das als wesentliche Bestandteile
a) eine unter Einwirkung von aktinischer Strahlung eine starke Säure bildende Verbindung und
b) eine polymere Verbindung mit wiederkehrenden, durch Säure spaltbaren Acetal- oder Ketalgruppen
enthält.

Das erfindungsgemäße Gemisch ist dadurch gekennzeichnet, daß die polymere Verbindung das Reaktionsprodukt aus
ba) einer polymeren organischen Verbindung mit freien OH-Gruppen,
bb) einer organischen Verbindung mit mindestens zwei Isocyanat- oder mindestens zwei Epoxygruppen und
bc) einer Verbindung mit wiederkehrenden, durch Säure spaltbaren Acetal- oder Ketalgruppen und mindestens einer freien OH-Gruppe ist.

Als strahlungsempfindlich sollen im Rahmen dieser Erfindung alle Systeme bezeichnet werden, die gegen elektromagnetische Strahlung im allgemeinen Sinn, d. h. gegen infrarotes, sichtbares, ultraviolettes Licht, energiereiche Strahlung, wie Röntgen-, Elektronen- und andere Korpuskularstrahlung empfindlich sind. Vorzugsweise liegt die Empfindlichkeit im kurzwelligen sichtbaren oder nahen bis mittleren Ultraviolettbereich. Die durch Bestrahlung Säure bildende Verbindung (a) kann jedoch auch gegenüber Licht, z. B. Tageslicht, beständig und gegenüber Elektronen- oder Röntgenstrahlung empfindlich sein. Auch Laserstrahlung kann ggf. zur Bebilderung eingesetzt werden.

Als polymere Verbindungen (ba) mit freien OH-Gruppen, insbesondere phenolischen OH-Gruppen, sind in erster Linie Phenolharze, bevorzugt Novolake geeignet. Außer den Phenol- und Alkylphenol-Aldehyd-Kondensationsharzen können auch Kondensationsharze von Naphtholen, wie sie in der US-A 4 551 409 beschrieben sind, oder Kondensationsharze von Ketonen und Phenolen, z. B. Pyrogallol-Acetonharze, eingesetzt werden. Auch die Polymeren der Vinylphenole, wie sie z. B. in der DE-A 34 06 927 beschrieben sind, die Polymeren des N-(4-Hydroxyphenyl)maleinimids, die in der EP-A 187 517 beschrieben sind, oder die in der DE-A 35 28 929 beschriebenen Polymerisate mit phenolischen OH-Gruppen sind geeignet. Ferner können modifizierte Phenolharze, z. B. die in der EP-A 150 315 oder der DE-A 24 29 251 angegebenen Polymeren, oder Polyamidcarbonsäuren mit freien phenolischen Hydroxygruppen verwendet werden.

Als Verbindungen (bc) mit säurespaltbaren Acetal- oder Ketalgruppen, die als Seitenketten in die Polymeren mit freien OH-Gruppen eingeführt werden, sind die in den DE-C 23 06 248 und insbesondere 27 18 254 beschriebenen Polyacetale geeignet. Bevorzugt werden die Polyacetale bzw. -ketale, in denen jedes α-Kohlenstoffatom der Alkoholkomponenten ein gesättigtes aliphatisches oder cycloaliphatisches, insbesondere primäres Kohlenstoffatom ist. Grundsätzlich sind alle derartigen Verbindungen einsetzbar, soweit sie über freie Hydroxygruppen oder andere funktionelle Gruppen verfügen, die zu einer Reaktion mit Isocyanat- oder Epoxygruppen befähigt sind.

Als Verbindungen mit Isocyanat- oder Epoxygruppen werden solche mit zwei oder mehreren, vorzugsweise zwei solchen funktionellen Gruppen eingesetzt, die dann die Funktion eines Vernetzers haben können. Beispiele sind Tolylendiisocyanat oder dessen Uretdion, Diphenylmethan-4,4′-diisocyanat, Naphthalin-1,5-diisocyanat, Hexamethylen-1,6-diisocyanat, 3,3,5-Trimethyl-hexamethylendiisocyanat, Isophorondiisocyanat und 4,4′-Diisocyanato-dicyclohexylmethan. Beispiele für bifunktionelle Epoxidverbindungen sind die Diglycidylether von Diphenolen, z. B. die Kondensationsprodukte aus Epichlorhydrin und Hydrochinon, 4,4′-Dihydroxy-diphenyl, 4,4′-Dihydroxy-diphenylpropan (Bisphenol A), 4,4′-Dihydroxy-diphenylsulfon oder 1,5-Dihydroxy-naphthalin. Bevorzugt sind die Produkte auf Basis von Bisphenol A, die kommerziell auch in höheren Kondensationsgraden erhältlich sind, z. B. mit Epoxidäquivalentgewichten von 180 bis 4000.

Ein Teil der Vernetzer kann auch durch monofunktionelle Verbindungen wie etwa Phenylisocyanat oder Phenylglycidylether ersetzt werden, wenn ein geringeres Ausmaß an Vernetzung erwünscht oder erforderlich ist. Ebenso kann ein Teil der bifunktionellen Vernetzer durch polyfunktionelle ersetzt werden, wie etwa Biurettriisocyanat (Desmodur N der Bayer AG), Triphenylmethantriisocyanat (Desmodur R der Bayer AG), ferner die trifunktionellen Isocyanate Desmodur L und IL der Bayer AG oder Glycidylether von Novolaken (ECN-Harze der Ciba-Geigy AG).

Die Umsetzung wird normalerweise in Lösung in zwei Stufen durchgeführt, vorzugsweise bei erhöhter Temperatur und/oder in Gegenwart eines Katalysators. In der ersten Stufe wird das säurespaltbare Polyacetal mit dem Vernetzer umgesetzt zu einem Präpolymeren, welches noch zu einer weiteren Umsetzung befähigte Epoxid- oder Isocyanat-Gruppen enthält. Die Vollständigkeit dieser Umsetzung ist mit den gängigen analytischen Methoden zur Bestimmung der Isocyanat- bzw. Epoxidgehalte überprüfbar, d. h. es wird ermittelt, wann die errechnete Menge an NCO- bzw. Epoxidgruppen umgesetzt ist. Die erhaltenen Präpolymeren werden dann mit dem OH-Gruppen enthaltenden Polymeren umgesetzt, bis praktisch keine Epoxid- bzw. Isocyanatgruppen mehr nachweisbar sind.

Das Verhältnis von Vernetzer zu säurespaltbarer Verbindung wird im allgemeinen so gewählt, daß auf jede freie Hydroxygruppe der säurespaltbaren Verbindung ein Vernetzermolekül entfällt. Das Reaktionsprodukt der ersten Stufe enthält z. B. bei Verwendung von Diisocyanaten als Vernetzer in der Regel ein Homologengemisch aus Oligomeren mit Diurethaneinheiten und Polyacetalblöcken, wobei bei dem bevorzugten Molverhältnis von Polyacetal zu Diisocyanat von 1:2 hauptsächlich das Diisocyanat mit einer zentralen Polyacetalsequenz und zwei endständigen, über Urethangruppen gebundenen Isocyanatgruppierungen entsteht. Je nach gewünschter Vernetzungsdichte kann dieses Verhältnis aber auch über- oder unterschritten werden. Bei der zweiten Stufe der Umsetzung wählt man vorzugsweise Verhältnisse von deutlich mehr als 1 mol Hydroxygruppen des polymeren Bindemittels je mol Epoxid bzw. Isocyanat.

Das günstigste Molverhältnis wird im Einzelfall durch einfache Versuche ermittelt. In jedem Fall muß beachtet werden, daß der Mengenanteil an Vernetzer niedrig genug ist, daß das erhaltene Endprodukt noch in Beschichtungslösemitteln löslich bleibt. Andererseits kann es zur Erzielung eines möglichst großen Löslichkeitsunterschieds zwischen belichteten und unbelichteten Bereichen des lichtempfindlichen Gemischs erwünscht sein, den Anteil an Polyacetalgruppen enthaltendem Vernetzer im Reaktionsgemisch möglichst hoch zu wählen.

Typische Lösemittel für die Umsetzung sind solche ohne aktive Wasserstoffatome, z. B. Aceton, Butanon, Dimethylformamid, Dioxan, Tetrahydrofuran, 1,2-Dimethoxy-ethan, Dichlorethan. Als Katalysatoren eignen sich tertiäre Amine wie Triethylamin, N-Methyl-morpholin, Diazabicyclooctan, Dimethylanilin, Dimethylaminopyridin.

Für die Herstellung von strahlungsempfindlichen Gemischen werden die beschriebenen Verbindungen kombiniert mit einer unter Einwirkung von aktinischer Strahlung eine starke Säure bildenden Verbindung und ggf. einem polymeren Bindemittel, das keine säurespaltbaren Gruppen enthält.

Als solche polymeren Bindemittel eignen sich wasserunlösliche, in wäßrig-alkalischen Lösungen und organischen Lösemitteln lösliche oder zumindest quellbare Bindemittel. Dies sind im wesentlichen die gleichen Polymeren, wie sie zur Umsetzung mit den säurespaltbaren Verbindungen und den Vernetzern herangezogen werden. Die Menge dieser Bindemittel kann je nach Anwendungszweck und eingesetztem Umsetzungsprodukt sehr stark variieren. In manchen Fällen ist es möglich, ganz auf diese Bindemittel zu verzichten.

Im allgemeinen liegt der Mengenanteil, bezogen auf die nichtflüchtigen Bestandteile des Gemischs, bei 0 bis 65, vorzugsweise bei 0 bis 50 Gew.-%. Der Mengenanteil an spaltbarer Verbindung liegt gewöhnlich bei 35-99,5, vorzugsweise bei 40-99 Gew.-%.

Zusätzlich können noch zahlreiche andere Polymere mitverwendet werden, die entweder wasserlöslich oder aber alkaliunlöslich sein können, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Bindemittel. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Die Wirkung dieser halogenhaltigen Verbindungen kann auch durch bekannte Sensibilisatoren spektral beeinflußt und gesteigert werden.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethyl-benzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung der Schicht ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 0,01 mm empfiehlt es sich, relativ wenig Säurespender zu verwenden.

Schließlich können der lichtempfindlichen Schicht noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Schichtdicke der strahlungs- bzw. lichtempfindlichen Schicht richtet sich im wesentlichen nach dem vorgesehenen Anwendungszweck des Materials. Sie kann im allgemeinen zwischen etwa 500 nm und 0,08 mm, vorzugsweise 0,001 bis 0,05 mm liegen. Für Druckplatten und aus Lösungen aufzubringende Photoresistschichten werden Schichtdicken im Bereich von 0,001 bis 0,01 mm bevorzugt.

Zur Beschichtung des Trägermaterials werden die Schichtbestandteile im allgemeinen in einem Lösemittel gelöst. Die Wahl des Lösemittels richtet sich nach dem Beschichtungsverfahren, der Schichtdicke und den Trocknungsbedingungen. Geeignet sind prinzipiell alle Lösemittel, die mit den Schichtbestandteilen verträglich sind, wie z. B. Alkohole, Ketone, Ester, chlorierte Kohlenwasserstoffe etc.. Bevorzugt werden Gemische mit Glykolethern.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 0,01 mm sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 0,01 mm werden meist Metalle verwendet. Für Offsetdruckplatten können eingesetzt werden: mechanisch, chemisch oder elektrolytisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben.

Für die Trocknung nach der Beschichtung können die üblichen Geräte und Bedingungen übernommen werden, Temperaturen um 100° C und kurzfristig bis 120° C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Mit Vorteil werden Laserbestrahlungsgeräte, insbesondere automatische Verarbeitungsanlagen verwendet, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Röntgen- oder Ionenstrahlen können ebenfalls zur Bilderzeugung verwendet werden.

Die bildmäßig belichtete oder bestrahlte Schicht kann in bekannter Weise mit den für handelsübliche Naphthochinondiazid-Schichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate, -borate oder -hydroxide und ferner Netzmittel sowie ggf. kleinere Anteile organischer Lösungsmittel enthalten. In bestimmten Fällen sind auch Lösemittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Im folgenden werden Beispiele für bevorzugte Ausführungsformen des erfindungsgemäßen Aufzeichnungsmaterials angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

### Allgemeine Vorschrift zur Herstellung der Verbindungen 1 - 5

Das polymere Acetal und das Isocyanat wurden in einer 1. Menge Butanon gelöst und dann zwei Stunden zum Rückfluß erhitzt. Dann wurde das OH-Polymere in einer 2. Menge Butanon zugegeben und das Gemisch weitere zwei Stunden zum Rückfluß erhitzt. Es resultierte eine gebrauchsfertige Lösung. Alle Mengen sind in Gt angegeben.

**Tabelle I**

| Verbindung | Polyacetal | Isocyanat | 1.Menge Butanon | OH-Polymeres | 2.Menge Butanon | Feststoffgehalt der Lösung (%) |
|---|---|---|---|---|---|---|
| 1 | A 1 11,2 | I 1 7,35 | 118,0 | B 1 40,0 | 263,6 | 13,3 |
| 2 | A 2 24,0 | I 2 11 | 250,0 | B 1 43,6 | 195,4 | 15,0 |
| 3 | A 2 24,0 | I 2 10,4 | 150,0 | B 2 25,0 | 250,0 | 13,7 |
| 4 | A 3 24,0 | I 2 11,0 | 250,0 | B 3 12,0 | 64,5 | 13,0 |
| 5 | A 3 14,0 | I 2 11,0 | 197,0 | B 4 8,6 | 66,9 | 14,2 |

### Isocyanate:

- I 1: Diphenylmethan-4,4′-diisocyanat
- I 2: Tolylen-2,4-diisocyanat

### Polyacetale:

- A 1: Polyacetal aus Butyraldehyd und Triethylenglykol, Hydroxylzahl 146
- A 2: Polyacetal aus 2-Ethylbutyraldehyd und Triethylenglykol, Hydroxylzahl 140
- A 3: Polyacetal aus 2-Methylbutyralaldehyd und Triethylenglykol, Hydroxylzahl 142

### OH-Gruppen enthaltende Polymere:

- B 1: Poly-4-hydroxy-styrol,
Resin M von Maruzen Petrochemical Co.
- B 2: Phenol-Formaldehyd-Novolak,
Alnovol PN 320 der Hoechst AG
- B 3: Pyrogallol-Aceton-Harz,
PA-808 von Gun Ei Chem. Ind. Co.
- B 4: Resorcin-Formaldehyd-Novolak,
Alnovol VPN 99 der Hoechst AG

### Vorschrift zur Herstellung der Verbindung Nr. 6

20 Gt des Polyacetals A 2 und 19 Gt eines Diglycidylethers von Bisphenol A (Beckopox EP 140 der Hoechst AG, Epoxidäquivalentgewicht 190) wurden zusammen mit 1 Vt Triethylamin in 152 Gt Tetrahydrofuran 6 Stunden zum Rückfluß erhitzt. Dann wurden 50 Gt Poly-4-hydroxystyrol in 353 Gt Tetrahydrofuran zugesetzt und weitere 6 Stunden bei Rückfluß reagieren gelassen. Es resultierte eine gebrauchsfertige Lösung mit 15 Gew.-% Feststoffgehalt.

### Beispiele 1 bis 6

Diese Beispiele zeigen die Eignung der erfindungsgemäßen Verbindungen in strahlungsempfindlichen Schichten.

Es wurden Beschichtungslösungen hergestellt, auf in Salzsäure elektrolytisch aufgerauhte, in Schwefelsäure anodisierte und mit Polyvinylphosphonsäure hydrophilierte Aluminiumplatten aufgeschleudert und 2 Minuten bei 100° C getrocknet. Es resultierten Schichtdicken von 1,8µm. Die Platten wurden unter einer 5 kW Metallhalogenidlampe im Abstand von 110 cm durch einen Halbtonstufenkeil mit 13 Stufen einer Dichteabstufung von 0,15 belichtet und nach 10 Minuten Warten in einem wäßrig-alkalischen Entwickler folgender Zusammensetzung 1 Minute entwickelt:

| | |
|---|---|
| 8,5 Gt | Na₂SiO₃ x 9 H₂O, |
| 0,8 Gt | NaOH, |
| 1,5 Gt | Na₂B₄O₇ x 10 H₂O, |
| 89,2 Gt | Wasser |

Jede Beschichtungslösung enthielt 0,02 Gt Kristallviolettbase und die in Tabelle II angegebenen Mengen an weiteren Bestandteilen. Als Photoinitiator wurde 2-(4-Styrylphenyl)-4,6-bis-trichlormethyl-s-triazin und als Bindemittel ein Kresol-Formaldehyd-Novolak mit dem Schmelzbereich 105-120° C nach DIN 53181 eingesetzt.

Tabelle II gibt ferner an, bei welcher Belichtungszeit die Stufe 3 im Belichtungskeil offen ist.

**Tabelle II**

| Beispiel | Verbindung Nr., Gt Lösung | Photoinitiator Gt | Bindemittel Gt | Propylenglykolmonomethylether, Gt | Belichtungszeit Sekundun |
|---|---|---|---|---|---|
| 1 | 1 32,1 | 0,23 | 1,83 | 66,17 | 11 |
| 2 | 2 32,56 | 0,25 | 1,22 | 65,97 | 10 |
| 3 | 3 35,8 | 0,23 | 1,20 | 63,1 | 10 |
| 4 | 4 32,8 | 0,25 | 1,83 | 65,12 | 13 ¹⁾ |
| 5 | 5 26,1 | 0,23 | 2,4 | 71,6 | 10 |
| 6 | 6 40,66 | 0,23 | - | 59,43 | 9 ¹⁾ |

| | | | | | |
|---|---|---|---|---|---|
| ¹⁾ Entwicklerlösung wurde mit destilliertem Wasser auf das doppelte Volumen verdünnt. | | | | | |

### Beispiel 7

Dieses Beispiel zeigt den breiten Nacherwärmungsspielraum und die bessere Lagerstabilität von erfindungsgemäßen Druckplatten im Vergleich zu bekannten Druckplatten. Dabei wurden die Druckplatten der Beispiele 2 und 3 eingesetzt.

Als Vergleich wurde entsprechend den Beispielen 1 bis 6 eine Druckplatte aus folgender Beschichtungslösung hergestellt:

| | |
|---|---|
| 4,7 Gt | Kresol-Formaldehyd-Novolak (Schmelzpunkt nach Kapillarmethode DIN 53 181: 105-120° C), |
| 1,4 Gt | Polyacetal aus 2-Ethylbutyraldehyd und Triethylenglykol, |
| 0,23 Gt | 2-(4-Styrylphenyl)-4,6-bis-trichlormethyl-s-triazin und |
| 0,02 Gt | Kristallviolett-Base in |
| 59,65 Gt | Propylenglykolmonomethylether und |
| 34 Gt | Butanon. |

Auf einen Teil dieser Vergleichsplatten wurde die folgende Lösung aufgeschleudert:

| | |
|---|---|
| 4,0 Gt | Polyvinylalkohol (K-Wert 8, 12 % Restacetylgruppen), |
| 1,0 Gt | Polyvinylpyrrolidon, (Luviskol K 30 der BASF AG) |
| 0,05 Gt | p-Nonylphenol-polyoxyethylenether (ca. 10 Oxyethyleneinheiten), |
| 94,95 Gt | destilliertes Wasser |

Es wurde eine Schichtdicke von 500 nm nach 2-minütiger Trocknung bei 100° C erhalten. Der andere Teil der Platten wurde unverändert belassen und diente als Vergleich.

Die Platten wurden unter einer 5-kW-Metallhalogenid-Lampe im Abstand von 110 cm durch einen Halbtonstufenkeil mit 13 Dichtestufen von je 0,15 zehn Sekunden belichtet und nach zehn Minuten Warten in dem Entwickler von Beispiel 1 30 Sekunden entwickelt:
Tabelle III gibt die Ergebnisse wieder. In Spalte A ist die Zahl der offenen Stufen bei einer Wartezeit von zehn Minuten bei Raumtemperatur nach der Belichtung, in Spalte B die Zahl der offenen Stufen nach einer Minute Erwärmen auf 100° C nach der Belichtung angegeben. Spalte C gibt an, wann nach Lagerung bei 100° C bei der Entwicklung Ton auftritt, und Spalte D gibt das Entwicklungsverhalten an.

**Tabelle III**

| | A | B | C | D |
|---|---|---|---|---|
| Druckplatte von Beispiel 2 | 3 | 3 | tonfrei nach 8 Stunden | Entwicklung einwandfrei |
| Druckplatte von Beispiel 3 | 3 | 3 | tonfrei nach 8 Stunden | Entwicklung einwandfrei |
| Vergleichsdruckplatte ohne Deckschicht | 3 | 1 | Ton nach 6 Stunden | Entwicklung einwandfrei |
| Vergleichsdruckplatte mit Deckschicht | 3 | 3 | tonfrei nach 8 Stunden | Entwicklung beeinträchtigt |

### Beispiel 8

Dieses Beispiel zeigt die Eignung des erfindungsgemäßen Aufzeichnungsmaterials zur Herstellung von Flachdruckplatten.

Eine in Salpetersäure elektrolytisch aufgerauhte, in Schwefelsäure anodisierte und mit Polyvinylphosphonsäure hydrophilierte Aluminiumplatte wurde mit folgender Lösung schleuderbeschichtet:

| | |
|---|---|
| 1,83 Gt | Novolak wie in Beispiel 1, |
| 32,1 Gt | Verbindung Nr. 1 (als Lösung), |
| 0,20 Gt | 2-(4-Styrylphenyl)-4,6-bis-trichlormethyl-s-triazin und |
| 0,02 Gt | Kristallviolettbase in |
| 65,85 Gt | Butanon |

Es wurde eine Schichtdicke von 2500 nm erhalten. Die Platte wurde 11 Sekunden bildmäßig mit einer 5 kW-Metallhalogenidlampe im Abstand von 110 cm belichtet, eine Minute auf 80° C erwärmt und dann im Entwickler aus Beispiel 1 eine Minute entwickelt. Mit der so hergestellten Offsetdruckform wurden 100.000 Drucke von einwandfreier Qualität erhalten.

### Beispiel 9

Dieses Beispiel zeigt die Eignung des erfindungsgemäßen Aufzeichnungsmaterials für die Bebilderung mit Elektronenstrahlen.

Auf mechanisch aufgerauhtes Aluminium wurde eine Lösung folgender Zusammensetzung aufgeschleudert:

| | |
|---|---|
| 2,4 Gt | Novolak wie in Beispiel 1, |
| 16,1 Gt | Verbindung Nr. 5 (als Lösung), |
| 0,20 Gt | 2-(4-Ethoxy-naphth-1-yl)-4,6-bis-trichlormethyl-s-triazin und |
| 0,02 Gt | Kristallviolettbase in |
| 71,60 Gt | Butanon |

Es wurde eine Schichtdicke von 1000 nm erhalten. Die Bestrahlung erfolgte mit 11 kV-Elektronen. Bei einem Strahlstrom von 5·10⁻⁶ A reichen 4 Sekunden Bestrahlungsdauer aus, um ein Feld von 10 Quadratzentimetern nach 60 Sekunden Einwirkung des Entwicklers aus Beispiel 1 löslich zu machen. Dies entspricht einer Empfindlichkeit der oben genannten Schichten von 2·10⁻⁶ C/cm².

### Beispiel 10

Dieses Beispiel zeigt die Eignung des erfindungsgemäßen Materials als Ätzreserve.

Auf eine Kupferplatte wurde die folgende Lösung durch Schleudern aufgebracht:

| | |
|---|---|
| 5 Gt | Novolak wie in Beispiel 1, |
| 90 Gt | Verbindung Nr. 4 (als Lösung), |
| 0,5 Gt | 2-(4-Ethoxy-naphth-1-yl)-4,6-bis-trichlormethyl-s-triazin und |
| 0,1 Gt | Kristallviolettbase in |
| 31,7 Gt | Ethanol. |

Nach 10 Minuten Trocknen bei 100° C resultierte eine Schichtdicke von 0,025 mm. Es wurde mit einer 5 kW-Metallhalogenidlampe (110 cm Abstand) ca. 100 Sekunden belichtet und nach einer Wartezeit von 15 Minuten 90 Sekunden mit dem in Beispiel 1 angegebenen Entwickler entwickelt. Die entstandene Resistschablone wies eine hervorragende Ätz- und Galvanoresistenz auf, insbesondere beim galvanischen Aufbau von Kupfer und Pb/Sn-Legierung.

### Beispiel 11

Dieses Beispiel zeigt die Eignung des erfindungsgemäßen Aufzeichnungsmaterials als hochauflösende Photoresistschablone.

Auf einen mit einem SiO₂-Film bedeckten Silicium-Wafer wurde die folgende, durch ein Filter mit einem Porendurchmesser von 200 nm (Millipore) filtrierte Lösung aufgeschleudert:

| | |
|---|---|
| 97,3 Gt | Verbindung Nr. 6 (als Lösung) und |
| 0,1 Gt | 2-(4-Styrylphenyl)-4,6-bis-trichlormethyl-s-triazin in |
| 2,6 Gt | 2-Ethoxy-ethylacetat. |

Nach 1 Minute Trocknen bei 100° C wurde eine Dicke von 1000 nm erhalten. Eine Testbildmaske wurde in innigen Kontakt mit dem Wafer gebracht, der 15 Sekunden mit UV-Licht einer Intensität von 4,5 mW/cm² bei 365 nm belichtet wurde. Nach 10 Minuten Warten wurde 45 Sekunden mit dem Entwickler aus Beispiel 1 entwickelt. Das erhaltene Bildmuster zeigte eine Auflösung von 1000 nm.

## Patentansprüche

1. Strahlungsempfindliches Gemisch, das als wesentliche Bestandteile
a) eine unter Einwirkung von aktinischer Strahlung eine starke Säure bildende Verbindung und
b) eine polymere Verbindung mit wiederkehrenden, durch Säure spaltbaren Acetal- oder Ketalgruppen
enthält, dadurch gekennzeichnet, daß die polymere Verbindung das Reaktionsprodukt aus
ba) einer polymeren organischen Verbindung mit freien OH-Gruppen,
bb) einer organischen Verbindung mit mindestens zwei Isocyanat- oder mindestens zwei Epoxygruppen und
bc) einer Verbindung mit wiederkehrenden, durch Säure spaltbaren Acetal- oder Ketalgruppen und mindestens einer freien OH-Gruppe ist.

2. Strahlungsempfindliches Gemisch nach Anspruch 1, dadurch gekennzeichnet, daß es ferner
c) ein von durch Säure spaltbaren Gruppen freies polymeres Bindemittel enthält.

3. Strahlungsempfindliches Gemisch nach Anspruch 2, dadurch gekennzeichnet, daß das Bindemittel wasserunlöslich und in wäßrig-alkalischen Lösungen löslich ist.

4. Strahlungsempfindliches Gemisch nach Anspruch 1, dadurch gekennzeichnet, daß die polymere organische Verbindung ba) ein Phenolharz ist.

5. Strahlungsempfindliches Gemisch nach Anspruch 1, dadurch gekennzeichnet, daß die Verbindung
bc) eine Verbindung mit wiederkehrenden Acetal- oder Ketalgruppen in der Hauptkette ist, in der jedes α-Kohlenstoffatom der Alkoholkomponente der Acetal- oder Ketaleinheiten aliphatisch ist.

6. Verfahren zur Herstellung eines strahlungsempfindlichen Gemischs gemäß Anspruch 1, dadurch gekennzeichnet, daß man eine Verbindung (bc) mit wiederkehrenden, durch Säure spaltbaren Acetal- oder Ketalgruppen und mindestens einer freien OH-Gruppe mit einer organischen Verbindung (bb) mit mindestens zwei Isocyanat- oder mindestens zwei Epoxygruppen in stöchiometrischem Überschuß umsetzt und das erhaltene, freie Isocyanat- oder Epoxygruppen enthaltende Reaktionsprodukt mit einer polymeren organischen Verbindung (ba) mit freien OH-Gruppen umsetzt und das erhaltene polymere Reaktionsprodukt mit seitenständigen säurespaltbaren Gruppen mit einer unter Einwirkung von aktinischer Strahlung eine starke Säure bildenden Verbindung vermischt.

7. Verfahren nach Anspruch 6, dadurch gekennzeichnet, daß man eine Verbindung (bc) mit mehr als einer freien OH-Gruppe im Molekül einsetzt und daß man einen Teil der organischen Verbindung (bb) mit mindestens zwei Isocyanat- oder mindestens zwei Epoxygruppen durch eine Verbindung mit einer Isocyanat- bzw. einer Epoxygruppe ersetzt.

8. Verfahren nach Anspruch 6 oder 7, dadurch gekennzeichnet, daß man das Molverhältnis der Verbindungen (bc) und (bb) so wählt, daß jede Verbindung (bc) an mindestens einer OH-Gruppe mit einer Isocyanat- oder Epoxygruppe umgesetzt wird.

## Claims

1. A radiation-sensitive mixture which contains, as essential constituents:
a) a compound which forms a strong acid on exposure to actinic radiation, and
b) a polymeric compound containing repeating acid-cleavable acetal or ketal groups,
wherein the polymeric compound is the reaction product of:
ba) a polymeric organic compound containing free OH groups,
bb) an organic compound containing at least two isocyanate groups or at least two epoxy groups, and
bc) a compound containing repeating acid-cleavable acetal or ketal groups and at least one free OH group.

2. A radiation-sensitive mixture as claimed in claim 1, which further contains
c) a polymeric binder free of acid-cleavable groups.

3. A radiation-sensitive mixture as claimed in claim 2, wherein the binder is water-insoluble and soluble in aqueous alkaline solutions.

4. A radiation-sensitive mixture as claimed in claim 1, wherein the polymeric organic compound ba) is a phenolic resin.

5. A radiation-sensitive mixture as claimed in claim 1, wherein the compound
bc) is a compound containing repeating acetal or ketal groups in the main chain in which each α-carbon atom of the alcohol component of the acetal or ketal units is aliphatic.

6. A process for preparing a radiation-sensitive mixture as claimed in claim 1, which comprises reacting a compound (bc) containing repeating acid-cleavable acetal or ketal groups and at least one free OH group with an organic compound (bb) containing at least two isocyanate groups or at least two epoxy groups in stoichiometric excess and reacting the reaction product obtained which contains free isocyanate groups or epoxy groups with a polymeric organic compound (ba) containing free OH groups and mixing the polymeric reaction product obtained which contains lateral acid-cleavable groups with a compound which forms a strong acid on exposure to actinic radiation.

7. The process as claimed in claim 6, wherein a compound (bc) containing more than one free OH group in the molecule is used and wherein a part of the organic compound (bb) containing at least two isocyanate groups or at least two epoxy groups is replaced by a compound containing one isocyanate group or one epoxy group respectively.

8. The process as claimed in claim 6 or 7, wherein the molar ratio of the compounds (bc) and (bb) is so chosen that each compound (bc) is reacted at at least one OH group with an isocyanate group or an epoxy group.

## Revendications

1. Composition sensible aux radiations, qui contient en tant que composants essentiels
a) un composé formant un acide fort sous l'effet d'un rayonnement actinique et
b) un composé polymère à groupes répétitifs cétal ou acétal séparables par un acide,
caractérisée en ce que le composé polymère est le produit de réaction obtenu à partir de
ba) un composé organique polymère à groupes OH libres,
bb) un composé organique comportant au moins deux groupes isocyanate ou au moins deux groupes époxy, et
bc) un composé comportant des groupes répétitifs cétal ou acétal séparables par un acide et au moins un groupe OH libre.

2. Composition sensible aux radiations selon la revendication 1, caractérisée en ce qu'elle contient en outre
c) un liant polymère exempt de groupes séparables par un acide.

3. Composition sensible aux radiations selon la revendication 2, caractérisée en ce que le liant est insoluble dans l'eau et soluble dans des solutions aqueuses-alcalines.

4. Composition sensible aux radiations selon la revendication 1, caractérisée en ce que le composé organique polymère ba) est une résine phénolique.

5. Composition sensible aux radiations selon la revendication 1, caractérisée en ce que le composé
bc) est un composé comportant des groupes répétitifs cétal ou acétal dans la chaîne principale, dans laquelle chaque atome de carbone α du composant alcool des motifs acétal ou cétal est aliphatique.

6. Procédé pour la préparation d'une composition sensible aux radiations selon la revendication 1, caractérisé en ce que l'on fait réagir un composé (bc), comportant des groupes répétitifs cétal ou acétal séparables par un acide et au moins un groupe CH libre, avec un composé organique (bb) comportant au moins deux groupes isocyanate ou au moins deux groupes époxy, en excès stoechiométrique, et on fait réagir le produit de réaction obtenu, contenant des groupes isocyanate ou époxy libres, avec un composé organique polymère (ba) à groupes OH libres, et on mélange le produit polymère de réaction obtenu, à groupes latéraux séparables par un acide, avec un composé formant un acide fort sous l'effet d'un rayonnement actinique.

7. Procédé selon la revendication 6, caractérisé en ce que l'on utilise un composé (bc) comportant plus d'un groupe OH libre dans sa molécule, et en ce que l'on remplace une partie du composé organique (bb), comportant au moins deux groupes isocyanate ou au moins deux groupes époxy, respectivement par un composé comportant un groupe isocyanate ou un groupe époxy.

8. Procédé selon la revendication 6 ou 7, caractérisé en ce que l'on choisit le rapport molaire des composés (bc) et (bb) de manière à faire réagir chaque composé (bc) au niveau d'au moins un groupe OH avec un groupe isocyanate ou époxy.
